Europäisches Patentamt

European Patent Office

Office européen des brevets

(11) Publication number: **0 316 940 B1**

## EUROPEAN PATENT SPECIFICATION

(45) Date of publication of patent specification: **15.07.92**   (51) Int. Cl.⁵: **H01L 21/225**

(21) Application number: **88119222.3**

(22) Date of filing: **18.11.88**

(54) Method for doping impurity material into a semiconductor substrate for fabricating a semiconductor device.

(30) Priority: **20.11.87 JP 294601/87**

(43) Date of publication of application:
**24.05.89 Bulletin 89/21**

(45) Publication of the grant of the patent:
**15.07.92 Bulletin 92/29**

(84) Designated Contracting States:
**DE FR GB**

(56) References cited:
**EP-A- 0 262 034**
**FR-A- 2 080 610**
**US-A- 3 532 563**
**US-A- 3 834 939**
**US-A- 4 512 868**

(73) Proprietor: **FUJITSU LIMITED**
**1015, Kamikodanaka Nakahara-ku**
**Kawasaki-shi Kanagawa 211(JP)**

(72) Inventor: **Nakamura, Moritaka c/o Fujitsu**
**Limited**
**Patent Department 1015 Kamikodanaka**
**Nakahara-ku Kawasaki-shi Kanagawa 211(JP)**

(74) Representative: **Greenstreet, Cyril Henry et al**
**Haseltine Lake & Co. Hazlitt House 28 South-**
**ampton Buildings Chancery Lane**
**London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to a method of doping a semiconductor substrate in a process of fabricating a semiconductor device. In particular, it relates to a method of impurity doping a semiconductor substrate wherein the semiconductor substrate is exposed to no plasma through all the fabricating steps thereof.

There are several methods for doping impurity atoms, donor atoms or acceptor atoms, into a semiconductor substrate, such as methods based on ion implantation, gas-to-solid diffusion, and solid-to-solid diffusion.

The ion implantation method has the advantage that patterns and concentrations of implanted regions are precisely controlled, but has the disadvantages that the apparatus required is expensive and that the surface of the semiconductor substrate is damaged by ion bombardment, in which the ions are accelerated by a high potential, e.g. 50 kV.

The gas-to-solid diffusion method has the disadvantage that its performance is sensitive to the surface condition of the semiconductor substrate to be doped, and the efficiency of the process is rather low because liquid impurity source material is generally used.

The solid-to-solid diffusion method has the advantage that the fabrication process is simple and can be performed at low cost, but it has the disadvantage that control of the impurity doping is rather difficult.

Known solid-to-solid diffusion methods include, for example, methods wherein a silicic acid compound liquid (such as BPF and OCD, products of Tokyo Ohka Co.) containing impurity material, is coated on the surface of a semiconductor substrate using a spin coating method. In US-A-3 834 939 a doped silicon dioxide layer is formed on a semiconductor substrate surface via heating of a layer of siloxane plus an alkoxide of the required dopant. In other known methods a layer of phospho-silicate glass or a boro-silicate glass is formed on a surface of a semiconductor substrate employing a CVD (chemical vapor deposition) method. Thereafter, in both cases, the semiconductor substrate is subjected to a heat treatment to diffuse, for example, phosphorus (P) atoms or boron (B) atoms contained in the glass layer into the semiconductor substrate.

In the solid-to-solid diffusion methods described above, an excess glass layer remaining on the surface of the semiconductor substrate must be removed by dissolving the residual glass layer with hydrofluoric acid solution, leading to a troublesome process. Furthermore, during the process of spin-coating the layer of the silicate glass, the coating material tends to stick easily to the tip of the nozzle for ejecting the solution, forming a dried solid block which is thereafter mixed in the coated glass layer, leaving particles in the layer. An alternative solid-to-solid diffusion method is described in US-A-3 532 563, wherein a doped, water-soluble, heat-decomposible polymer is deposited on a semiconductor substrate and patterned. On heating the polymer decomposes and the dopant simultaneously diffuses into the substrate.

Aiming to solve the above problem, and particularly to form shallow pn-junctions which are increasingly used in high integration density semiconductor devices, Fujimura et al. proposed a new method in a Japanese Patent Application, Publication No. 61-220191, filed on 10th September 1987. EP-A-0 202 034, valid under Article 54(3) and (4) EPC also describes such a method.

The method comprises the following steps: preparing photoresist containing impurity material suitable for supplying desired impurity atoms; forming a patterned layer of the photoresist on the surface of a semiconductor substrate; exposing the photoresist layer continuously for a period of time to a plasma generated from oxidizing source gas to cause the impurity atoms to be introduced into the semiconductor substrate and to ash the layer; immersing the substrate in chemical solutions to remove organic materials still remaining on the surface and silicon oxide film formed on the surface; and finally heating the semiconductor substrate to activate the impurity atoms introduced into the semiconductor substrate, thus forming doped regions in the semiconductor surface.

The method according to the patent application of Fujimura et al. is particularly suitable for forming shallow pn-junctions in a semiconductor substrate, and the lithographic technology and ashing technology employed therein are conventional and established ones. However, the method still has several disadvantages.

In the doping method of Fujimura et al., the photoresist layer is directly exposed to a gas plasma. This always damages the exposed surface of the semiconductor substrate owing to bombardment with ions, causing minor crystal defects in the semiconductor substrate. During the subsequent thermal diffusion processing, abnormal diffusion of the impurity can occur at the locations of the crystal defects, leading to undesirable characteristics of the associated semiconductor device. In addition, the plasma ion bombardment adversely affects shallow pn-junctions formed in the semiconductor substrate, seriously impairing the electrical characteristics of the semiconductor device.

The impurity atoms contained in the photoresist layer are introduced into the semiconductor substrate by the plasma. It is rather difficult to maintain a uniform distribution of the plasma over the irradiated surface, with the result that the distribution of density of impurity atoms (dopant) in the doped regions is non-uniform. This results in undesirable electrical characteristics of the semiconductor device.

The thickness of an insulator film beneath a gate electrode is reduced: it may for example be a silicon oxide film 20 nm (200 Angstroms) thick. In line with the reduction in thickness, the insulator film tends to be broken down more easily owing to accumulation of electrical charges on the film formed by the ions and electrons transferred from the plasma and attached to the surface of the gate electrode.

Furthermore, ion bombardment not only damages the bombarded surface of the semiconductor substrate, but also the kinetic energy of the ions raises the temperature of the substrate. For example, according to a study by the present inventor, the temperature went up to 250°C using the doping conditions: reaction gas oxygen at a pressure of ≈ 40 Pa (0.3 Torr), microwave layer 2450 MHz, and doping time 10 minutes. While there is a high-resolution photoresist which is suitable for fine, precise patterning, such as TSMR (a product of Tokyo Ohka Co.), such a high-resolution photoresist usually has low viscosity at a relatively high temperature. It has been observed by the present inventor that high-resolution photoresist TSMR which had been exposed to a plasma of oxygen gas during the doping process of Fujimura et al. was easily softened and started to flow, deforming the pattern of the photoresist layer. This results in the deformation of the pattern of the doped regions formed in the semiconductor substrate. Accordingly, such a high-resolution photoresist cannot be used in the above-mentioned doping method.

There is thus a need for an improved doping method free from the disadvantages described above, and in particular not involving ion bombardment.

An object of the present invention is to provide an improve impurity doping method.

An embodiment of the present invention can provide a method for selectively doping impurity atoms into a semiconductor substrate, without being subject to damage caused by ion bombardment, at a relatively low substrate temperature, and utilizing a conventional lithographic technique, resulting in a doping method with a favourable high efficiency.

To these ends, the present invention provides a doping method which is an improvement in the doping method of Fujimura et al. An embodiment of the method comprises the steps of: forming a layer of an organic high-molecular-weight compound containing impurity material, including acceptor atoms or donor atoms, on a surface of a semiconductor substrate; exposing the semiconductor substrate to reaction gas composed of electrically neutral reactive species containing atomic oxygen, to ash and remove the organic high-molecular-weight compound and to leave the impurity atoms on the surface; and thereafter raising the temperature of the semiconductor substrate to diffuse the residual impurity atoms into the semiconductor substrate to form doped regions therein. As the above-described reaction gas, ozone gas or oxidizing reactive neutral species, generated in a downstream-type plasma generating means, is used.

This method has the substantial advantage that the surface of the semiconductor substrate is, throughout the doping operation, entirely free from any damage caused by ion bombardment. As a result, adverse effects on the electrical characteristics of the relevant semiconductor device are avoided and the semiconductor substrate can be maintained at a favourable low temperature, thus allowing a wider choice of the relevant photoresist material. Other advantages are that the impurity doping density in doped regions is favourably uniform, that breakdown of a thin insulator film beneath a gate electrode caused by accumulation of electrical charges can be avoided, and that the doping process can be performed using simpler steps and with less expensive apparatus as compared with a conventional ion implantation method.

Embodiments of the invention will now be described with reference to the accompanying drawings, in which like reference numerals denote like parts, and in which:

Fig. 1(a) to Fig. 1(e) are diagrammatic cross-sectional views of a semiconductor substrate being subjected to a doping process according to the present invention, illustrating states at consecutive steps of the doping process;

Fig. 2 is a diagrammatic cross-sectional view of an ashing apparatus using ozone gas as reaction gas, employed in a first embodiment of the present invention; and

Fig. 3 is a diagrammatic cross-sectional view of an ashing apparatus including a plasma generating means of the downstream type for ashing photoresist, employed in a second embodiment of the present invention.

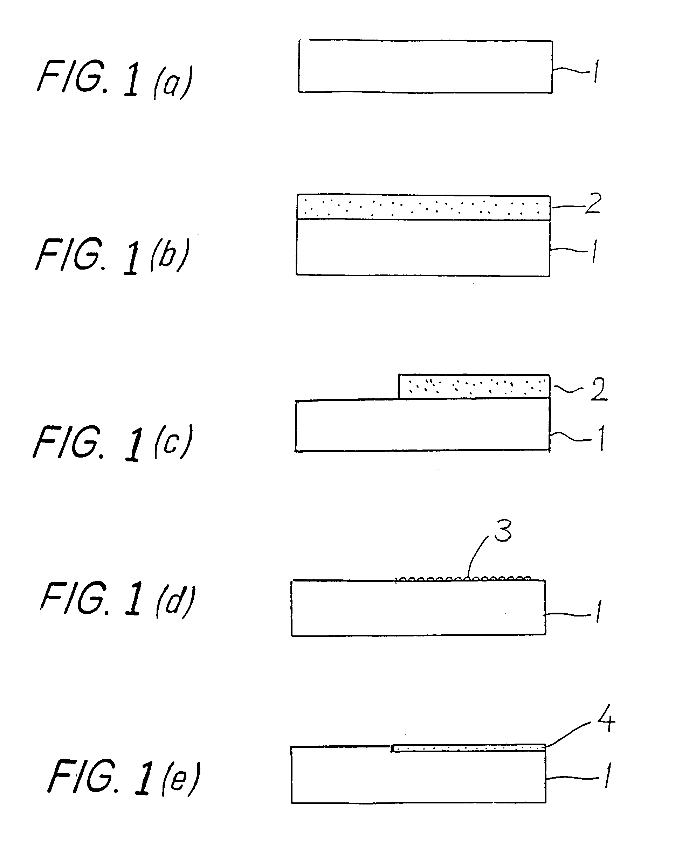

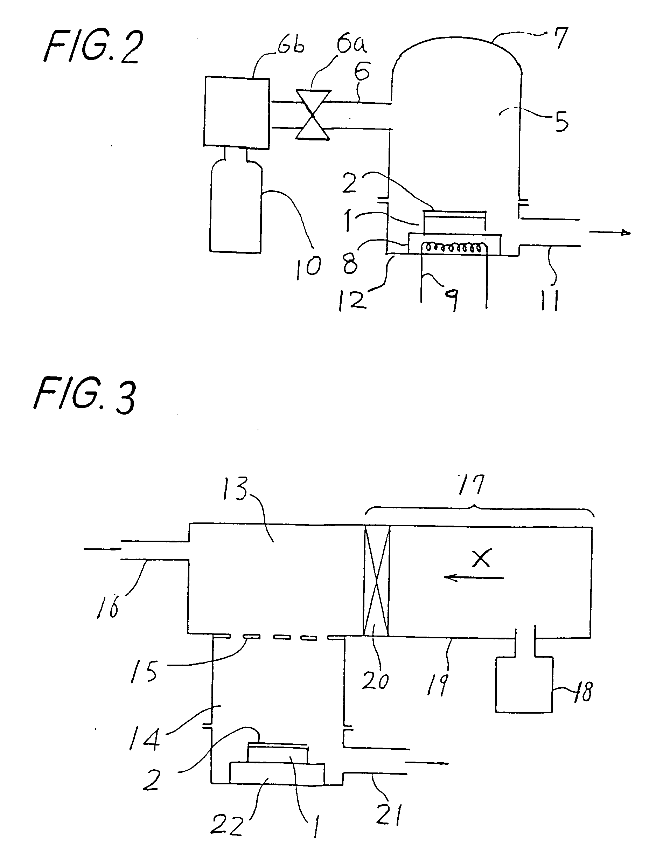

An example of a first embodiment of the present invention will be described with reference to Fig. 1(a) to Fig. 1(d) and Fig. 2.

A phosphorus (P) doped n-type, or boron (B) doped p-type semiconductor substrate 1 of monocrystalline silicon having a surface resistance of approximately 200 ohms/square centimetre is first prepared. A substantially diagrammatic cross-sectional view of the semiconductor substrate is shown in Fig. 1(a).

A photoresist is prepared containing impurity material such as boric acid (HBO$_3$) as a source of acceptor atoms or such as phosphorus pentoxide (P$_2$O$_5$) as a source of donor atoms. Because the temperature of the semiconductor substrate during the doping process is rather high, as described later, a high-resolution photoresist is not suitable, and a heat-resistant photoresist which has high viscosity at the substrate temperature, such as a photosensitive polyimide, should be used. An example of the composition of the above-described photoresist is:

| (1) photoresist: photoneece UR-3100 (a product of Toray Co.) | 200 cc |
| (2) HBO$_3$ or P$_2$O$_5$ | 2 g |
| (3) 2-methoxyethanol (solvent) | 100 cc. |

The photoresist is mixed with 2-methoxyethanol in which HBO$_3$ or P$_2$O$_5$ is dissolved. The photoneece UR-3100 is usable at a temperature up to 450°C.

Photoresist thus prepared is coated on a surface of the semiconductor substrate, 1 forming a 1 μm thick heat-resistant photoresist layer 2 as shown in Fig. 1(b). The coating of the photoresist is performed using a conventional spin coating method at a rotation speed of 5000 rpm. Thereafter, the semiconductor substrate 1 is baked at 120°C for approximately 2 minutes to vaporize the solvent, 2-methoxyethanol, in the photoresist layer.

Next, the photoresist layer 2 is patterned employing a conventional lithographic technique in a predetermined pattern as shown in Fig. 1(c).

Subsequently, the semiconductor substrate 1 is placed in an ashing apparatus, the cross-sectional view of which is shown diagrammatically in Fig. 2. The apparatus shown in Fig. 2 is a typical one comprising a reaction chamber 5 formed inside a bell jar 7 which is mounted vacuum-tightly on a base member 12. In the reaction chamber 5, a susceptor 8 is placed on the base member 12 to set the semiconductor substrate 1 on. The reaction chamber 5 can be evacuated using a conventional vacuum system (not shown) through an evacuating outlet tube 11. The susceptor 8 is heated by a heater 9 to heat the semiconductor substrate 1 up to a predetermined temperature. Oxygen (O$_2$) gas stored in a gas reservoir 10 is converted into ozone gas through an ozonizer 6b, and the ozone gas, as reaction gas, is fed into the reaction chamber 5 through a gas inlet tube 6 disposed at an upper portion of the bell jar 7. The flow rate of the reaction gas is controlled by a gas valve 6a disposed between the gas inlet tube 6 and the gas reservoir 10.

The reaction gas to ash the photoresist layer 2 is selected to be active, oxidizing, electrically neutral gas, typically, ozone gas. The use of ozone gas as reaction gas for ashing resist was disclosed by S. R. Shortes in United States Patent No. 4 341 592. Naturally, the semiconductor substrate exposed to the reaction gas is not subject to any bombardment of ions, and is thus free from damage caused by the ion bombardment. In order to achieve a desired ashing rate, the pressure of ozone gas and temperature of the semiconductor substrate 1 to be processed are suitably 1.01 x 10$^5$ Pa (one atm.) and from 250°C to 300°C respectively.

Thus, the ashing process is performed in the reaction chamber 5, with the result that the photoresist 2 is oxidised and removed as a vapourising gas, and a residual layer 3 of the above-described HBO$_3$ or P$_2$O$_5$ is selectively left on the surface of the semiconductor substrate 1 as shown in Fig. 1(d).

Thereafter, the semiconductor substrate 1 is heated at approximately 900°C for approximately 30 minutes in an atmosphere of non-active gas, such as nitrogen (N$_2$) gas. Consequently, an impurity diffusion layer 4, namely a doped region 4, having a depth of approximately 0.15 μm, is selectively formed in the semiconductor substrate 1 as shown in Fig. 1(e), and simultaneously the diffused impurity atoms are activated.

The first embodiment has the advantage that the ashing apparatus is simple and includes no plasma generating means, and the operation is also simple, leading to less costly apparatus and simplified fabrication steps.

With reference to Fig. 1(a) to Fig. 1(e) and Fig. 3, a second embodiment according to the present invention will now be described, wherein active, oxidising, electrically neutral reaction gas containing reactive neutral species supplied from a plasma generating means of downstream type disposed in the relevant ashing apparatus is used to ash a photoresist layer coated on a semiconductor substrate.

Before processing further, the ashing apparatus will be briefly described. Fig. 3 is a diagrammatic cross-sectional view of the ashing apparatus. The structural configuration of the ashing apparatus is disclosed in United States Patent, No. 4 512 868, published on 23rd April 1985, issued to Fujimura et al.

The apparatus includes a plasma generating means comprising an exciting means 17, a plasma generating chamber 13, and a reaction chamber 14 in which the semiconductor substrate 1 to be doped is

4

placed. The two chambers are separated by a perforated partition wall 15 having a number of small holes of approximately 4 mm in diameter (usually referred to as a punching board). The partition wall 15 is electrically grounded. In the plasma generating chamber 13, there is disposed a gas inlet tube 16 for introducing oxidizing gas as a source gas. The exciting device 17 outputs microwaves having a frequency of 2.45 GHz to irradiate the source gas introduced into the plasma generating chamber 13. The exciting device 17 comprises, for example, a magnetron 18, a waveguide 19 and a microwave transfer window 20 made of, for example, silicate glass, for transmitting the microwaves into the reaction chamber 13.

The reaction chamber 14 is evacuated by a conventional evacuating apparatus (not shown) through an evacuating tube 21. A susceptor 22 is placed in a bottom portion of the reaction chamber 14 to set the semiconductor substrate 1. A heater (not shown) is attached to the susceptor 22 to raise the temperature of the semiconductor substrate 1 set thereon to a predetermined temperature for a thermal diffusion process.

The plasma generating means is not limited to the microwave excited plasma generating means. It can be replaced by a radio frequency (RF) or ultra high frequency (UHF) excited plasma generating means or DC discharge plasma generating means.

In the second embodiment, the initial fabricating steps are the same as those of the preceding embodiment, except for the step for preparing photoresist material.

At first, a phosphorus (P) doped n-type, or boron (B) doped p-type semiconductor substrate 1 of monocrystalline silicon having a surface resistance of approximately 200 ohms/square centimetre is prepared as shown in Fig. 1(a).

In the second embodiment a high-resolution photoresist is used because the substrate temperature is low, e.g. 60°C as described later. The high-resolution photoresist contains impurity material such as boric acid $(HBO_3)$ as a source of acceptor atoms or impurity material such as phosphorus pentoxide $(P_2O_5)$ as a source of donor atoms, like that of the first embodiment. For example, a high-resolution photoresist having the following constituents can be used:

| | |
|---|---|
| (1) photoresist: OFPR800 with a viscosity of 30 centipoise (a product of Tokyo Ohka Co.) | 200 cc |
| (2) $HBO_3$ or $P_2O_5$ | 2 g |
| (3) 2-methoxyethanol (solvent) | 100 cc. |

The photoresist is mixed with the 2-methoxyethanol in which $HBO_3$ or $P_2O_5$ is dissolved.

Thus-prepared photoresist is coated on a surface of the semiconductor substrate 1, forming a 1 $\mu$m thick photoresist layer 2 as shown in Fig. 1(b). The coating of the photoresist is performed using a conventional spin coating method at a rotation speed of 5000 rpm. Thereafter, the semiconductor substrate 1 is baked at 120°C for 2 minutes or so to vapourise the solvent, 2-methoxyethanol, contained in the photoresist layer.

Next, the photoresist layer 2 is patterned employing a conventional lithographic technique in a predetermined pattern, as shown in Fig. 1(c).

Thereafter, the above-described semiconductor substrate 1 is set on the susceptor 18, and the plasma generating chamber 13 and the reaction chamber 14 are evacuated. Subsequently, oxidising source gas is introduced into the plasma generating chamber 13 through the gas inlet tube 16, being maintained at a predetermined gas pressure. Then, microwaves are output from the magnetron 18, being transmitted in a direction indicated by the arrow X, being transferred into the plasma generating chamber 13 through the microwave transfer window 20 and irradiating the source gas in the plasma generating chamber 13. Thus, a plasma is generated in the plasma generating chamber 13. For example, the source gas and microwave radiation used are as follows:

(1) source gas

oxygen $(O_2)$ 1500 cc + carbon tetrafluoride $(CF_4)$: 50 cc

gas pressure: 1.5 Torr ($\approx$ 200 Pa)

(2) microwaves: frequency: 2.45 GHz,

power: 1.5 kw.

A plasma generated under the above conditions contains ions, electrons, and electrically neutral and chemically active oxygen, namely oxygen reactive neutral species, containing oxygen atoms. The charged particles, ions and electrons in the plasma are captured by the partition wall 15, loosing the electric charge thereof. Only the electrically neutral reactive species of oxygen (O) can be transferred into the reaction chamber 14 through the small holes in the partition wall 15.

The oxidising reactive neutral species entering the reaction chamber 14 contact the photoresist layer 2, actively reacting with and oxidising the photoresist of the layer 2. The process of ashing the photoresist layer 2 on the semiconductor substrate 1 proceeds in the reaction chamber 14 for approximately 80 seconds. The photoresist layer is oxidised and removed as a vapourising gas, selectively leaving a residual layer 3 of the above-described $HBO_3$ or $P_2O_5$ as shown in Fig. 1(d). Hereby, the uniformity of the plasma density affects only the uniformity of the ashing rate of the engaged photoresist layer, but not the density distribution of impurity material in the residual layer 3. As a result, the density distribution of the impurity atoms in the resultant doped regions is not affected by a non-uniformly distributed plasma.

Thereafter, a thermal diffusion step for diffusing impurity atoms contained in the residual layer 3 into the semiconductor substrate 1 is performed in the same manner as in the first embodiment to form a doped region 4 selectively formed in the semiconductor substrate 1, as shown in Fig. 1(e). A p-type impurity diffusion layer which is formed using the photoresist 2 containing $HBO_3$ has an area resistance of approximately 45 ohms/square centimetre, and an n-type impurity diffusion layer 4 formed by $P_2O_5$ has an area resistance of approximately 40 ohms/square centimetre.

In the second embodiment, the depth of the impurity diffusion layers simply depends on the temperature of the semiconductor substrate 1 and the duration of the thermal diffusion process. Therefore, the depth of the doped regions 4 can be extended to a depth of 0.2 to 0.3 micrometers by prolonging the time of the heat treatment. When the reaction gas is composed of the above-described $O_2$ + $CF_4$, a desirable ashing rate can be obtained even though the temperature of the semiconductor substrate 1 is maintained at room temperature. Reaction gas composed of $O_2$ 1500 cc + nitrogen ($N_2$) instead of the above-described $O_2 + CF_4$, can also be used. However, a higher temperature of the semiconductor substrate 1 of approximately 200°C is required for diffusion of impurity atoms.

With respect to the above-described gases, a practically necessary ashing rate, such as a rate higher than 1.5 $\mu$m/minute is achieved under a low gas pressure of approximately 1 Torr. Such a low temperature ashing is effective to prevent peeling and deformation of a pattern made of the organic high-molecular-weight material 2, enabling selective doping of impurity into a minute region of the semiconductor substrate 1 to be effected.

In the above-described embodiments, a photoresist layer is used as an organic high-molecular-weight layer, and the layer is patterned so as to dope impurity atoms into predetermined regions on a surface of a semiconductor substrate 1. When a non-photosensitive organic high-molecular-weight layer other than a photoresist layer, e.g. conventional novolak resist, is used, the patterning thereof can be performed by forming a photoresist layer over the organic high-molecular-weight layer at first, and then by patterning the photoresist layer with a conventional lithographic technique. Thereafter, the organic high-molecular-weight layer can be patterned using the patterned photoresist layer as a mask.

It will be appreciated that an embodiment of the invention can comprise a method for fabricating a semiconductor device comprising the steps of: preparing a semiconductor substrate; preparing resist composed of an organic high-molecular-weight compound containing impurity material; forming a layer of said resist on a surface of said semiconductor substrate; patterning said resist layer in a predetermined pattern using a lithographic technique; exposing said patterned resist layer to reaction gas comprising neutral oxidising reactive species, thereby oxidising said organic high-molecular-weight compound of said layer, resulting in removing said resist layer while said impurity material selectively remains on said surface; and raising the temperature of said semiconductor substrate, thereby introducing impurity material into said semiconductor substrate to form a doped region having said predetermined pattern in said semiconductor substrate.

The present invention has been described by referring to several embodiments: however, modification of these within the scope of the subject matter of the present invention is possible. Since numerous modifications and changes will readily occur to those skilled in the art, it is not desired to limit the invention to the exact methods and application shown and described, and all suitable modifications and equivalents may be resorted to and fall within the scope of the invention and the claims and their equivalents.

**Claims**

1. A method for fabricating a semiconductor device comprising the steps of:
   (a) preparing resist composed of an organic high-molecular-weight compound containing impurity material;
   (b) forming a layer (2) of said resist on a surface of a semiconductor substrate (1);
   (c) patterning said resist layer in a predetermined pattern using a lithographic technique;
   (d) exposing said patterned resist layer to reaction gas comprising neutral oxidising reactive species, and containing no charged species, thereby oxidising said organic high-molecular-weight compound of said layer, resulting in removing said resist layer while said impurity material (3) selectively remains on said surface; and

(e) raising the temperature of said semiconductor substrate, thereby introducing impurity material into said semiconductor substrate to form a doped region (4) having said predetermined pattern in said semiconductor substrate.

2. A method for fabricating a semiconductor device, as claimed in claim 1, wherein said reaction gas is ozone gas.

3. A method for fabricating a semiconductor device, as claimed in claim 1 or claim 2, wherein said reaction gas is supplied by a downstream ashing apparatus employed in said step (e).

4. A method for fabricating a semiconductor device, as claimed in claim 3, wherein said downstream ashing apparatus comprises:

a plasma generating chamber (13) for generating plasma by introducing oxidising source gas therein under the application of exciting energy;

an evacuatable reaction chamber (14) disposed adjacent to said plasma generating chamber, being structured such that said semiconductor substrate (1) is mountable therein; and

perforated means (15) separating said plasma generating chamber from said reaction chamber and having a number of small holes, whereby said oxidising neutral species generated in said plasma are selectively allowed to pass from said plasma generating chamber to said reaction chamber through said perforated means and gas ions generated in said plasma are inhibited from entering said reaction chamber.

5. A method for fabricating a semiconductor device as claimed in claim 4, wherein said step (e) comprises the steps of:

mounting said semiconductor substrate in said reaction chamber; and

operating said downstream ashing apparatus so that said reaction gas containing oxidising neutral species is generated in said plasma generating chamber and enters said reaction chamber to contact said semiconductor substrate.

6. A method for fabricating a semiconductor device comprising the steps of:

(a) forming a layer of an organic high-molecular-weight resist compound containing impurity atoms on a surface of a semiconductor substrate;

(b) exposing said semiconductor substrate to reaction gas composed of neutral oxidising species containing atomic oxygen and containing no charged species, thereby oxidising and removing said organic high-molecular-weight resist compound of said layer, selectively leaving said impurity atoms on said surface; and

(c) raising the temperature of said semiconductor substrate, thereby diffusing said impurity atoms into said semiconductor substrate to form a doped region in said semiconductor substrate.

7. A method for fabricating a semiconductor device as claimed in claim 6, wherein said reaction gas is ozone gas.

8. A method for fabricating a semiconductor device as claimed in claim 6, wherein said organic high-molecular-weight compound is photoresist.

9. A method for fabricating a semiconductor device as claimed in claim 6, wherein said step (a) further comprises a step for patterning said organic high-molecular resist layer in a predetermined pattern.

**Revendications**

1. Procédé de fabrication d'un dispositif à semiconducteur comprenant les étapes de :

(a) préparation d'une résine constituée par un composé organique de poids moléculaire élevé qui contient un matériau d'impuretés ;

(b) formation d'une couche (2) de ladite résine sur une surface d'un substrat semiconducteur (1) ;

(c) conformation de ladite couche de résine selon un motif prédéterminé en utilisant une technique de lithographie ;

(d) exposition de ladite couche de résine conformée à un gaz de réaction comprenant des espèces

7

réactives neutres oxydantes et ne contenant aucune espèce chargée pour ainsi oxyder ledit composé organique de poids moléculaire élevé de ladite couche, d'où l'enlèvement de ladite couche de résine tandis que ledit matériau d'impuretés (3) reste de manière sélective sur ladite surface ; et (e) augmentation de la température dudit substrat semiconducteur pour ainsi introduire un matériau d'impuretés à l'intérieur dudit substrat semiconducteur afin de former une région dopée (4) présentant ledit motif prédéterminé dans ledit substrat semiconducteur.

2. Procédé de fabrication d'un dispositif à semiconducteur selon la revendication 1, dans lequel ledit gaz de réaction est du gaz ozone.

3. Procédé de fabrication d'un dispositif à semiconducteur selon la revendication 1 ou 2, dans lequel ledit gaz de réaction est appliqué par un dispositif de destruction aval utilisé dans ladite étape (e).

4. Procédé de fabrication d'un dispositif à semiconducteur selon la revendication 3, dans lequel ledit dispositif de destruction aval comprend :
   une chambre de génération de plasma (13) pour générer un plasma en introduisant du gaz de source oxydant à l'intérieur sous l'application d'une énergie d'excitation ;
   une chambre de réaction dans laquelle on peut faire le vide (14) disposée de manière à être adjacente à ladite chambre de génération de plasma, cette chambre étant structurée de telle sorte que ledit substrat semiconducteur (1) puisse être monté dedans ; et
   un moyen perforé (15) qui sépare ladite chambre de génération de plasma de ladite chambre de réaction et qui comporte un certain nombre de petits trous et ainsi, lesdites espèces neutres oxydantes générées dans ledit plasma se voient autorisées de manière sélective à passer depuis ladite chambre de génération de plasma dans ladite chambre de réaction au travers dudit moyen perforé et des ions gazeux générés dans ledit plasma sont empêchés d'entrer dans ladite chambre de réaction.

5. Procédé de fabrication d'un dispositif à semiconducteur selon la revendication 4, dans lequel ladite étape (e) comprend les étapes de :
   montage dudit substrat semiconducteur dans ladite chambre de réaction ; et
   mise en fonctionnement dudit dispositif de destruction aval de telle sorte que ledit gaz de réaction qui contient les espèces neutres oxydantes soit généré dans ladite chambre de génération de plasma et pénètre à l'intérieur de ladite chambre de réaction pour entrer en contact avec ledit substrat semiconducteur.

6. Procédé de fabrication d'un dispositif à semiconducteur comprenant les étapes de :
   (a) formation d'une couche d'un composé de résine organique de poids moléculaire élevé contenant des atomes d'impuretés sur une surface d'un substrat semiconducteur ;
   (b) exposition dudit substrat semiconducteur à un gaz de réaction constitué par des espèces oxydantes neutres qui contient de l'oxygène atomique et qui ne contient aucune espèce chargée pour ainsi oxyder et ôter ledit composé de résine organique de poids moléculaire élevé de ladite couche en laissant de manière sélective lesdits atomes d'impuretés sur ladite surface ; et
   (c) augmentation de la température dudit substrat semiconducteur pour ainsi diffuser lesdits atomes d'impuretés à l'intérieur dudit substrat semiconducteur afin de former une région dopée dans ledit substrat semiconducteur.

7. Procédé de fabrication d'un dispositif à semiconducteur selon la revendication 6, dans lequel ledit gaz de réaction est du gaz ozone.

8. Procédé de fabrication d'un dispositif à semiconducteur selon la revendication 6, dans lequel ledit composé organique de poids moléculaire élevé est une résine photo-sensible.

9. Procédé de fabrication d'un dispositif à semiconducteur selon la revendication 6, dans lequel ladite étape (a) comprend en outre une étape de conformation de ladite couche de résine organique de poids moléculaire éleve selon un motif prédéterminé.

**Patentansprüche**

1. Ein Verfahren zur Herstellung einer Halbleiteranordnung mit den Schritten:

(a) Vorbereiten eines Resists, welches aus einer organischen Verbindung mit hohem Molekulargewicht besteht, die Verunreinigungsmaterial enthält;

(b) Bilden einer Schicht (2) des genannten Resists auf einer Oberfläche eines Halbleitersubstrats (1);

(c) Mustern der genannten Resistschicht unter Verwendung eines lithografischen Verfahrens;

(d) Aussetzen der genannten gemusterten Resistschicht einem Reaktionsgas, welches neutrale oxydierende reaktive Arten umfaßt und keine geladenen Arten enthält, wodurch die genannte organische Verbindung mit hohem Molekulargewicht der genannten Schicht oxydiert, was dazu führt, daß die genannte Resistschicht entfernt wird, wogegen das genannte Verunreinigungsmaterial (3) auf der genannten Oberfläche selektiv verbleibt; und

(e) Erhöhen der Temperatur des genannten Halbleitersubstrats, wodurch Verunreinigungsmaterial in das genannte Halbleitersubstrat eingebracht wird und eine dotierte Zone (4) entsteht, welche das vorherbestimmte Muster in dem genannten Halbleitersubstrat hat.

2. Ein Verfahren zur Herstellung einer Halbleiteranordnung nach Anspruch 1, bei welchem das genannte Reaktionsgas Ozongas ist.

3. Ein Verfahren zur Herstellung einer Halbleiteranordnung nach Anspruch 1 oder Anspruch 2, bei welchem das genannte Reaktionsgas von einer stromabwärtigen Veraschungsapparatur, welche im genannten Schritt (e) verwendet wird, geliefert wird.

4. Ein Verfahren zur Herstellung einer Halbleiteranordnung nach Anspruch 3, bei welchem die genannte stromabwärtige Veraschungsapparatur umfaßt:

eine plasmaerzeugende Kammer (13) zur Erzeugung von Plasma unter Zuführung von oxydierendem Quellgas unter Anwendung von Erregungsenergie;

eine evakuierbare Reaktionskammer (14), die angrenzend an die genannte plasmaerzeugende Kammer angeordnet und so gestaltet ist, daß das genannte Halbleitersubstrat (1) darin installiert werden kann; und

perforierte Mittel (15), welche die genannte plasmaerzeugende Kammer von der genannten Reaktionskammer abtrennen und eine Anzahl kleiner Löcher haben, wodurch die genannten oxydierenden neutralen Arten, die in dem genannten Plasma erzeugt werden, von der genannten plasmaerzeugenden Kammer zu der genannten Reaktionskammer durch die genannten perforierten Mittel selektiv gelangen können, und Gasionen, die in dem genannten Plasma erzeugt werden, am Eindringen in die genannte Reaktionskammer gehindert sind.

5. Ein Verfahren zur Herstellung einer Halbleiteranordnung nach Anspruch 4, bei welchem der genannte Schritt (e) die Schritte umfaßt:

Installieren genannten Halbleitersubstrats in der genannten Reaktionskammer; und

Betreiben der genannten stromabwärtigen Veraschungsapparatur, so daß das genannte Reaktionsgas, welches oxydierende neutrale Arten enthält, in der genannten plasmaerzeugendem Kammer erzeugt wird und in die genannte Reaktionskammer eindringt, um mit dem genannten Halbleitersubstrat in Kontakt zu kommen.

6. Ein Verfahren zur Herstellung einer Halbleiteranordnung mit den Schritten:

(a) Bilden einer Schicht einer organischen Resistverbindung mit hohem Molekulargewicht, welche Verunreinigungsatome auf einer Oberfläche eines Halbleitersubstrats enthält;

(b) Aussetzen des genannten Halbleitersubstrats einem Reaktionsgas, welches aus neutralen oxydierenden Arten besteht, die atomaren Sauerstoff enthalten und keine geladenen Arten enthalten, wodurch die genannte organische Resistverbindung mit hohem Molekulargewicht der genannten Schicht oxydiert und entfernt wird, wobei genannte Verunreinigungsatome auf der genannten Oberfläche selektiv hinterlassen werden; und

(c) Erhöhen der Temperatur des genannten Halbleitersubstrats, wodurch die genannten Verunreinigungsatome in das genannte Halbleitersubstrat eindringen und eine dotierte Zone in dem genannten Halbleitersubstrat bilden.

7. Ein Verfahren zur Herstellung einer Halbleiteranordnung nach Anspruch 6, bei welchem das genannte Reaktionsgas Ozongas ist.

8. Ein Verfahren zur Herstellung einer Halbleiteranordnung nach Anspruch 6, bei welchem die genannte organische Verbindung mit hohem Molekulargewicht ein Photoresist ist.

9. Ein Verfahren zur Herstellung einer Halbleiteranordnung nach Anspruch 6, bei welchem der genannte Schritt (a) ferner einen Schritt zur Musterung der genannten organischen Resistschicht mit hohem Molekulargewicht zu einem vorherbestimmten Muster umfaßt.

FIG. 1 (a)

1

FIG. 1 (b)

2

1

FIG. 1 (c)

2

1

FIG. 1 (d)

3

1

FIG. 1 (e)

4

1

FIG.2

FIG.3